# EUROPEAN PATENT SPECIFICATION

(11) **EP 2 294 608 B1**
(45) Date of publication and mention of the grant of the patent: **19.04.2017**
(21) Application number: 09794850.9
(22) Date of filing: 30.04.2009
(51) Int. Cl.: H01L 21/205, C30B 25/10, C23C 16/44, C23C 16/48, C30B 25/08, H01L 21/67

(54) **MODULAR AND READILY CONFIGURABLE REACTOR ENCLOSURES**
MODULARE UND KONFIGURATIONSBEREITE REAKTORGEHÄUSE
ENCEINTES DE REACTION MODULAIRES ET FACILEMENT CONFIGURABLES

(30) Priority: 30.06.2008 US 77028 P
(43) Date of publication of application: 16.03.2011
(73) Proprietor: Soitec, 38190 Bernin (FR)
(72) Inventor: BERTRAM, Ronald, Thomas, Jr., Mesa AZ 85212 (US)
(74) Representative: Grünecker Patent- und Rechtsanwälte PartG mbB
(86) International application number: PCT/US2009/042281
(87) International publication number: WO 2010/005620

(56) References cited:
- KR-A- 20050 013 879
- US-A- 3 862 397
- US-A- 5 156 461
- US-A- 6 042 652
- US-B1- 6 331 212

## Description

### FIELD OF THE INVENTION

The present invention is related to the field of materials processing systems, in particular to chemical vapor deposition (CVD) systems, and provides modular CVD reactor enclosures that can be readily reconfigured to meet the specific needs of individual CVD processes, including permitting external monitoring of conditions internal to a chamber.

### BACKGROUND OF THE INVENTION

Chemical vapor deposition (CVD) processes are commonly used in the semiconductor arts, e.g., to grow and process wafers of semiconducting materials. CVD processes are conducted in CVD reactor chambers designed to withstand the high temperatures and corrosive atmospheres that commonly occur.

CVD reactor chambers for semiconductor processing are commonly configured so that process gases enter above and flow vertically downward towards a growing wafer (see, e.g., US 6,167,834), or so that process gases enter at a lateral side of the chamber and flow horizontally across the growing wafer (see, e.g., US 4,828,224). Vertical-flow chambers are often of a generally circular shape, whilst horizontal-flow chambers are often of a generally rectangular with process gases flowing horizontally along the chambers' longer (longitudinal) axes. The latter types of reactors and improvements thereto have been extensively described (see, e.g., US 4,828,224; 4,836,138; 5,221,556; 6,093,252; 6,143,079; 6,167,834; 6,465,761; and 7,173,216).

CVD reactor chambers used in semiconductor processes are also almost always heated. Certain chambers, known in the art as "hot wall", are heated by directly heating the chamber walls, the interior components being indirectly heated by heat transferred from the hot walls. Other chambers, known in the art as "cold wall", are constructed from transparent quartz, the interior components being directly heated by infra-red (IR) radiation transmitted through the chamber walls from exterior heating lamps.

Cold wall chambers commonly have heating lamps (either linear or circular) arranged to cover and/or surround the upper face, lower face, or both faces. For example, US 4,836,138 and 6,456,761 describe cold-wall reactor chambers with horizontally-flowing process gases which are retained in reactor enclosures and heated by banks of heating lamps held in the enclosures above and below the reactor chambers. The banks above the reactor chamber have heating lamps oriented along the long axis of the chamber and parallel to the longitudinal flow of process gases, whilst the banks beneath the reactor chamber have lamps oriented along the short axis of the chamber and perpendicular to the longitudinal gas flow. As in most prior chambers, both banks of lamps span the length of the reactor chamber in their respective dimensions: lamps of the upper bank are oriented along the longer longitudinal dimension and span or cover most or all of the upper wall; and lamps of the lower bank are oriented along the shorter transverse dimension and span or cover most or all of the lower wall. The 90° offset between the upper and lower banks of lamps provides improved axially uniformity of radiation.

Additional heating lamps can be provided to supplement the upper and lower banks of heating lamps. For example, US 4,836,138 and 6,167,834 describe cold wall reactors which, in addition to upper and lower banks of heating lamps, have additional heating lamps placed in radiation concentrating enclosures below the reactor chamber. These bulbs are usually centrally arranged about the susceptor shaft and serve to heat the susceptor and other regions that otherwise would not be heated due to the difficulty of arranging linear heat lamps in those regions. US5156461 discloses a modular CVD reactor comprising an independent lamp module module with integrated means for wafer temperature monitoring adapted to be mounted in a structurally independent way on a reactor enclosure supporting a CVD reactor chamber. The quality of products grown and processed in a CVD reactor chamber benefits from monitoring and control of conditions within the chamber, e.g., the temperature profile of the wafer, the thickness of the wafer, surface characteristics of the wafer, the composition and temperature of the process gases in the vicinity of the wafer, and so forth. Although possible, it is not desirable to perform such monitoring by instruments placed within a reactor chamber, as such instruments would need to resist the high temperatures and harsh atmospheres that develop within a reactor chamber during most semiconductor processes.

Instead, instruments are preferably positioned external to the reactor chamber and monitor interior conditions by responding to radiation passing through the transparent chamber walls. Such instruments are known. For example, internal temperatures can be externally measured by pyrometers; properties of a semiconductor wafer internal to the chamber can be externally measured from light reflected from the wafer; properties of gases internal to the chamber, e.g., in the vicinity of a semiconductor wafer, can be externally measured by observing the spectra of light passing through the chamber and near to the wafer.

However, external measuring instruments are difficult if not impossible to use in connection with cold wall CVD reactor chambers heated using the commonly-available configurations of heating lamps, e.g., the configurations described above. Simply put, these configurations have heating lamps that extend for most or all of a chamber's longitudinal and transverse dimensions, thus occupying and occluding most or all of the faces of the chamber. Heating lamps as commonly arranged leave no room for external instruments to observe the interior of the chamber.

The inventors are not aware of prior art teachings describing how external measuring instruments can be used in conjunction with conventional cold wall CVD reactor chambers with conventional arrangements of heating lamps. However, use of external measuring instruments is desirable for routine and robust monitoring of processes occurring interior to chamber.

### SUMMARY OF THE INVENTION

The present invention relates to a modular chemical vapor deposition (CVD) reactor sub-system of claim 1 and a method for configuring a modular CVD reactor sub-system of claim 11. Generally, the present disclosure provides improved enclosures and associated function modules, e.g., heating function modules, metrology function modules, and the like, for CVD reactor chambers, in particular, for CVD reactor chambers oriented so that process gases pass horizontally from inlets, across a growing epilayer, and to an exhaust. A modular reactor enclosure of this disclosure along with a CVD reactor and appropriate associated function modules of this invention (a "reactor sub-system"), can be combined and configured so as to be particularly adapted to individual CVD processes, and such a reactor sub-system can be combined with known, supporting sub-systems (e.g., a gas handling sub-system) to form a functional CVD system. Preferred CVD reactor chambers are made at least partially of quartz transparent to a broad range of electromagnetic (EM) radiation and are operated in a manner known in the art as "cold wall", and preferred configurations include metrology function modules for externally sensing conditions internal to a reactor chamber having walls, at least partially, of quartz.

Briefly, a modular reactor enclosure of the disclosure is sized and configured to provide (at least) a mechanical framework that can support and hold a CVD reactor chamber and one or more associated function modules of one or more function types. The mechanical framework of the enclosure supports the function modules external to the CVD reactor chamber in such a manner that both the modules and the chamber (collectively, "supported modules") can be readily replaced and rearranged. The enclosure also retains the supported modules so that, although capable of being readily replaced and rearranged, they can be sufficiently fixed so that processes can be reliably performed within the CVD reactor chamber. Preferably, a reactor enclosure of the disclosure can accommodate a range of associated function modules of the disclosure along with a range of commercially-available CVD reactor chambers. Importantly, preferred function modules, e.g., preferred metrology function modules, require no machining or alteration of a (often relatively fragile) quartz reactor with which they are configured.

The present disclosure also includes the associated function modules that, along with a CVD reactor chamber, are supported and held by a reactor enclosure of this disclosure external to the reactor chamber. The function modules typically include a mechanical framework which supports and holds one or more sensors of one or more types. The mechanical framework of each function module is sized and configured so as to cooperate with a reactor enclosure in order that function modules can be readily placed (e.g., in the enclosure), replaced, held, and released; it is thus structurally independent of, and not integral with, the framework of the reactor enclosure. The mechanical frameworks of different function modules of different types are preferably jointly sized and configured (e.g., into standard sizes) so that a single reactor enclosure can support and hold different configurations of function modules of differing function types. Preferred sensors are responsive to conditions internal to the reactor chamber by measuring radiation passing from the reactor interior through transparent portions of the reactor walls. Optional sensors can also be responsive to external conditions.

Function modules are not limited to providing a single function. Rather function modules of the disclosure can be multi-function modules that provide multiple different functions or multiple types of a single function to nearby portions of a CVD reactor chamber and interior. for example, a single function module can also provide both heating and metrology functions to nearby portions of a CVD reactor chamber and interior. More specifically, preferred embodiments of this disclosure permit improved and flexible metrology functions that can be configured for use with typical, horizontal flow, cold-wall CVD chambers. Known cold wall reactor chambers are often constructed at least partially from quartz material (or other transparent material), and therefore can be heated by radiation, from heating lamps, that passes into the reactor through the quartz walls. Advantageously, transparent portions of the chamber walls can also permit monitoring of conditions interior to the chamber interior using sensors responsive to EM (electromagnetic) radiation that passes from the reactor through the walls to the exterior. Although highly advantageous, such external monitoring has not been previously possible for the following reasons: cold wall reactors have been conventionally mounted in reactor enclosures supporting fixed banks of heating lamps adjacent to the horizontal walls of the chamber; and such fixed banks of heating lamps heating lamps have conventionally been constructed so as to obstruct and block chamber walls thereby preventing external sensors for observing the chamber interior.

In this context, improvements provided by preferred embodiments of the present invention can be viewed, in part, as removing the conventional upper heating lamps and instead providing heating lamps in heating function modules that can be arranged above the reactor chamber so as to permit sensors to access part of the upper chamber surface. For example, in one embodiment of the invention, upper heating elements can be divided and arranged into a plurality of independent function modules that can be positioned, removed, exchanged, and the like, to improve operation of the reactor and the process conducted therein. Preferably, in order to facilitate access to the upper surface of the reactor, heating elements (e.g. lamps) in such heating function modules can be rotated through 90° (i.e., to a direction perpendicular to gas flow) in comparison with those of the fixed upper heating elements commonly in the prior art. Generally, lower heating elements are more than capable of making up for any heating capacity lost by rearrangement of upper heating elements.

Sensors can then be arranged in areas no longer obstructed by the upper heating lamps, preferably, to probe regions surrounding the epilayer, or to probe the epilayer itself, or to probe other regions. Examples of the metrology that such sensors make possible include, but are not limited to, temperature control, gas composition analysis, epilayer thickness, epilayer surface roughness, and so forth. This metrology data can be used to more accurately control processes being conducting with the chamber, and ultimately, to lead to improved product.

Optionally, lower heating elements can also be placed in heating function modules, which can then be oriented parallel or perpendicular to process gas flow. Modularization of the lower heating elements can further permit: sensor access to the chamber lower surface (although measurements at the lower surface generally acquire less critical data); arrangement of heating elements in the vicinity of input and output fixtures; addition or modification of precursors, e.g., by producing plasmas internal to the chamber or chamber inlets.

The present disclosure also provides methods for configuring reactor sub-systems made possible by the modular reactor enclosures and independent function modules of this disclosure Generally, configuration being with selecting new function modules to be used with a reactor sub-system and selecting locations along the reactor chamber where the selected function modules should be supported. Generally, a function module supported at a particular location provides functions to the nearby portions of the reactor chamber and its interior, and multiple function modules supported at multiple locations provides a spatial distribution or profile of functions. Next, any function modules currently supported at the selected locations that are different from the intended new function modules are removed, and the selected function modules are mounted and supported on the reactor enclosure at the selected locations. Such configuration can be performed without any structural modification to the reactor enclosure or to the CVD reactor chamber. Typically, it can be no more time consuming or difficult than performing a routine maintenance.

If a reactor sub-system is being configured for a selected process, the modules and locations are preferably selected to provide a profile and distribution of functions within the chamber suitable for the selected process. For example, the selected process may be best performed if heat is supplied to the reactor chamber in a particular spatial distribution or profile. For such a process, heating function modules should be selected and positions for the modules selected to provide the particular heating profile. Similarly, the selected process may be best performed if certain characteristics of the chamber interior at certain locations within the chamber can be monitored, and metrology function modules and positions can be selected to provide the particular measurement distribution or profile.

The present disclosure also provides kits of function modules which can be used for configuring compatible reactor enclosures. The function modules and the reactor enclosures can be mutually configured and sized and sized as described herein to permit ready reconfiguration and rearrangement of a reactor sub-system. For example, an installation could stock such a kit so that reactor-sub-systems can be configured to new requirements without delay.

More specifically, in one embodiment, the disclosure provides a modular chemical vapor deposition (CVD) reactor sub-system including a modular reactor enclosure, a CVD reactor chamber supported by the reactor enclosure, and a plurality of independent function modules supported by the reactor enclosure adjacent to the exterior walls of the CVD chamber but otherwise structurally independent of the reactor enclosure. Each function module provides one or more functions to nearby portions of the CVD reactor chamber and interior that are useful to processes carried out within the CVD chamber. The reactor enclosures and function modules are preferably mutually configured and sized so that at least one function module can be supported by the reactor enclosure at a plurality of different positions adjacent to the exterior walls of the reactor chamber.

A function module can have a longer dimension oriented in a direction perpendicular to process gas flow within the chamber, and a shorter dimension in a direction parallel to process gas flow, or vice versa. A function module preferably includes at least one housing that is structurally independent of and removable from the reactor enclosure, and one or more function elements supported by the housing and providing the functions performed by the module. Function elements supported by the module housing can include heating elements for providing heat to nearby portions of the CVD reactor chamber and interior. One or more of the heating elements can be radiant heating elements emitting radiation to which the walls of the reactor chamber are at least partially transparent. A plurality of heating function modules can be supported by the reactor enclosure at corresponding positions so as to provide a selected profile of heat to the CVD chamber interior.

Function elements supported by the module housing can also include one or more sensors for measuring conditions in nearby portions of the CVD reactor chamber and interior. Metrology function module can include a wide variety of sensors, such as a sensor for determining composition of gases internal to the CVD reactor chamber by measuring the spectral properties of light transmitted through gases, a sensor for determining temperatures internal to the CVD reactor chamber by measuring radiation emitted from within the reactor chamber, a sensor for determining the thickness of a surface within the reactor chamber by measuring radiation reflected from the surface, a sensor for determining the roughness of a surface within the reactor chamber by measuring radiation reflected from the surface, or other sensors known in the art. A plurality of metrology function modules can be supported by the reactor enclosure at corresponding positions so as to measure selected conditions in a plurality of different portions of the CVD chamber interior.

In another embodiment, the disclosure provides methods for configuring the modular CVD reactor sub-systems of the disclosure (such as a modular CVD reactor sub-system of the previous embodiment). According to the methods provided: first, one or more independent function modules are selected, and, for each selected function module, corresponding portions of the CVD chamber and interior are selected; then any function modules that are supported by the reactor enclosure nearby to the selected portions of the CVD chamber and interior are removed; and finally each selected function module is supported on the reactor enclosure adjacent to exterior walls of the CVD chamber that are nearby to the corresponding portion of the CVD reactor chamber and interior selected for that function module. A function module already supported by the reactor enclosure nearby to a certain position need not be removed if it provides functions similar to the functions provided by the module selected to be mounted nearby to that certain position.

Selected function modules can include one or more heating function modules for providing heat to the CVD reactor chamber and interior, or one or more metrology function modules for measuring selected conditions in the interior of the CVD reactor chamber, or other types of function modules. Corresponding portions of the CVD reactor chamber and interior can be chosen for selected heating function modules so that, when the heating function modules are mounted nearby to the chosen corresponding portions, heat is provided to the CVD reactor chamber and interior according to a preferred heating profile. Similarly, corresponding portions of the CVD reactor chamber and interior can be chosen for selected metrology modules so that, when the metrology function modules are mounted nearby to the selected corresponding portions, measurements of the interior of the CVD chamber are made according to a preferred measurement profile. Preferably, heating and metrology profiles are determined in dependence on a particular CVD process to be performed.

The disclosure also provides modular CVD reactor sub-systems of the disclosure configured according to the methods of the disclosure (such as a method for configuring of the previous embodiment).

In a further embodiment, the disclosure provides one or more independent function modules, and kits of independent function modules, that can be used to configure and reconfigure modular CVD reactor sub-systems of the disclosure. An independent function module preferably includes at least one housing that is structurally independent of, and removable from, the reactor enclosure, and one or more function elements supported by the function module housing. The independent function module and the modular reactor enclosure are preferably mutually configured and sized so that the function module can be supported by the reactor enclosure adjacent to the exterior walls of the reactor chamber at a plurality of different positions. Also, when supported at a particular position adjacent to the exterior walls of the reactor chamber, the independent function module provides one or more functions to nearby portions of the CVD reactor chamber and interior that are useful to processes carried out within the CVD chamber.

Function elements can includes heating elements for providing heat to nearby portions of the CVD reactor chamber and interior and sensor elements for measuring conditions in nearby portions of the CVD reactor chamber and interior. Metrology function modules can include a wide variety of sensors, such as a gas composition sensor, a surface properties sensor, a temperature sensor, and other sensors known in the art.

A single function module can also provide multiple different functions, such as a function module providing both heating and metrology functions.

Headings are used herein for clarity only and without any intended limitation. A number of references are cited herein, the entire disclosures of which are incorporated herein, in their entirety, by reference for all purposes. Further, none of the cited references, regardless of how characterized above, is admitted as prior to the invention of the subject matter claimed herein. Further aspects and details and alternate combinations of the elements of this invention will be apparent from the following detailed description and are also within the scope of the inventor's invention.

### BRIEF DESCRIPTION OF THE DRAWINGS

The present invention may be understood more fully by reference to the following detailed description of the preferred embodiment of the present invention, illustrative examples of specific embodiments of the invention and the appended figures in which:
Fig.1 illustrates an exemplary prior art reactor enclosure with fixed heating elements;
Figs.2A-C illustrates embodiments of the invention with various heating function modules;
Fig. 3A-B illustrate embodiments of the invention with various heating function modules and various metrology function modules;
Figs. 4A-C schematically illustrate details of function modules of the invention;
Figs. 5A-B schematically illustrate details of function modules of the invention;
Fig. 6 illustrates a transverse section of a reactor enclosure of the invention with function modules of the invention and with a conventional reactor chamber.

### DETAIL DESCRIPTION OF THE PREFERRED EMBODIMENTS

Preferred embodiments of modular, reconfigurable reactor enclosures of this invention are now described. However, prior to doing so, a brief description of a conventional, prior art, reactor enclosure is provided.

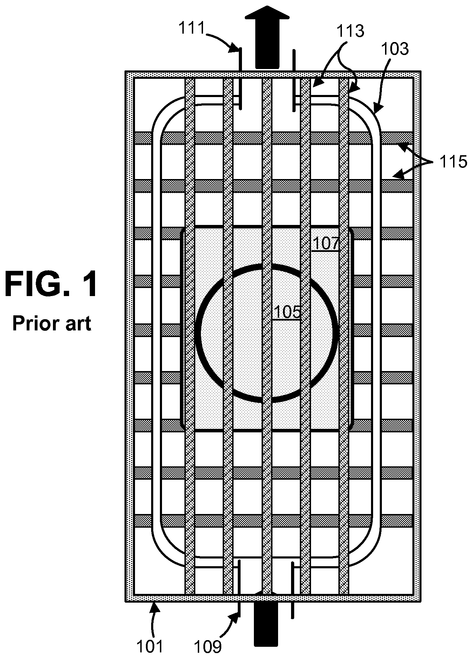

Fig.1 (prior art) illustrates a schematic plan view of relevant aspects of a conventional, prior art reactor enclosure, which being presented for purposes of explanation, is not necessarily a technically accurate representation of any particular prior art reactor enclosure nor of any particular prior art reactor chamber. Reactor enclosure or housing 101 supports and retains CVD reactor chamber 103 which is commonly of transparent quartz and which includes within such common components as susceptor 105, for holding semiconductor wafers (epilayers), and susceptor control plate 107, for improving temperature stability of the susceptor. Process gases enter reactor chamber 103 through inlet or inlets 109 structured to produce desired patterns of gas flow. The gases then flow across one or more epilayers on susceptor 105, where they react to deposit material or process the epilayers, after which they exit the chamber through exhaust 111.

Fig. 1 also illustrates radiant heating elements 113 and 115 which heat the susceptor and epilayers to process temperatures (e.g., 1000 °C and above). IR radiation from the radiant heating elements, e.g., heat lamps and so forth, passes with little absorption through the reactor chamber walls to be absorbed by, and thereby to heat, components internal to the chamber. The quartz chamber walls remain at relatively lower temperatures (thus such a configuration is known as "cold wall") since they are, at most, indirectly heated by the directly heated internal components. Radiant heating elements can include conventional lamps with resistive filaments, light-emitting solid state structures (see, e.g., US 7,173,216), or other radiative devices. Radiative heating elements can also be combined conductive heating elements.

The heating elements frequently extend, as here illustrated, between fixtures, sockets, or the like (not illustrated) that are permanently attached to the walls of reactor enclosure 101. The heating-element fixtures are frequently configured and arranged so that a number of heating elements, elements 113, are positioned in reactor enclosure 101 above reactor chamber 103 (the upper bank) in order to heat the upper surfaces of components internal to the reactor, e.g., susceptor 105. Further heating-elements fixtures are frequently configured and arranged so that additional heating elements, elements 115, are positioned in the reactor enclosure below the reactor chamber (the lower bank) in order to heat the lower surfaces of internal components. The upper and lower banks of heating elements are frequently oriented perpendicularly to each other, with the upper bank being commonly oriented (in the prior art) along the longer, longitudinal axis (along which process gases flow from inlet to exhaust) to provide more even heating. In the following, without intended limitation, radiative heating elements are also referred to as "heat lamps", although heat lamps are known to be only one type of radiative heating elements.

Turning to the present invention, new reactor enclosures are provided that are of improved modularity, improved capability, and improved flexibility in comparison to known, prior-art reactor enclosures, such as the one described above. In preferred embodiments of the invention, heating elements are not supported by the reactor enclosure itself, but instead are supported in one or more independent modules, referred to herein as "heating function modules", the modules being supported and retained by the reactor enclosure. In preferred embodiments the invention also includes independent modules having functions other than heating, e.g., modules providing metrology functions. Function modules are not limited to providing a single function, but can be multi-function modules that provide multiple different functions or multiple types of a single function to nearby portions of a CVD reactor chamber and interior.

A reactor enclosure can then be configured with one or more metrology function modules as well as one or more heating function modules. Because of the independence and modularity of the function modules of different function types, a single reactor enclosure can also support and retain different numbers of function modules of different types in different arrangements at different times. These capabilities are made possible because the reactor enclosures and independent function modules are designed to be physically compatible, e.g., by being of standard sizes and having standard and reversible attachment means.

Description of these and other features of the invention is facilitated in the following by use of the term "configuration" to refer to the current numbers and current types of function modules being supported and retained by a reactor enclosure, and use of the term "arrangement" to refer to the current physical layout of function modules in the reactor enclosure. Accordingly, a single reactor enclosure can have different configurations (e.g., different numbers and types) of function modules at different times; and a single reactor enclosure with a single configuration can have different arrangements (e.g., different placements or layouts) of function modules at different times.

Further, the term "support" is used to refer to supporting elements against gravity and the like, while the term "retain" is used to refer to keeping an element in a sufficiently fixed position so that a CVD process can be performed. Function modules are supported by providing an embodiment with supporting means (to be described) (which can also act as retaining means). In some embodiments, function modules can be retained simply by being supported, while in other embodiments retaining means (to be described) (which can also act as supporting means) are provided. Further, the term "length" is generally used to refer to the long dimension of a structure, while the term "width" is generally used to refer to the short dimension of a structure. A "longitudinal" direction is generally one that is along (or parallel) to the direction of gas flow in the chamber, while a "transverse" direction is generally one that is perpendicular to the direction of gas flow in the chamber. The length of a structure can be either longitudinal or transverse, with the width then being transverse or longitudinal, respectively.

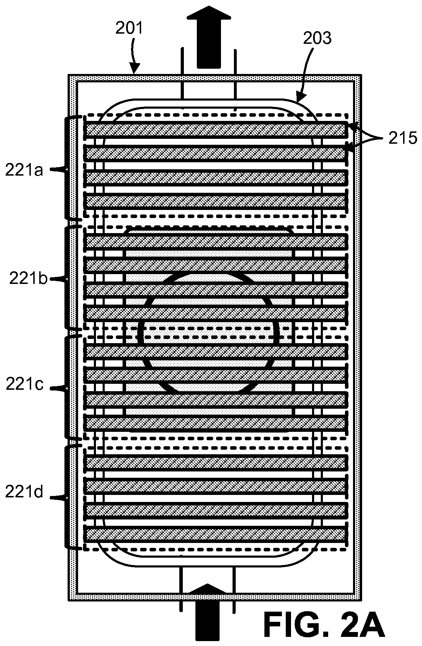

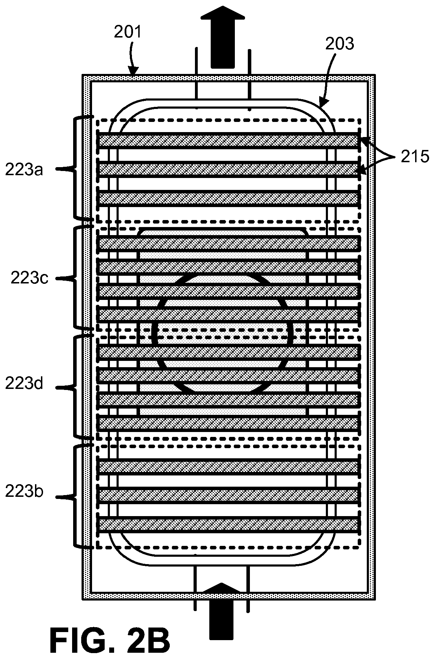

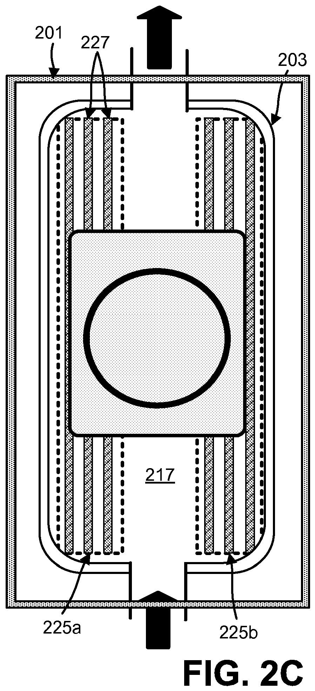

These and other aspects of preferred embodiments of the invention are now described in more detail with reference to Figs. 2-6. Generally, these figures illustrate reactor enclosures 201, 301, and 603 of the invention supporting and retaining conventional quartz CVD reactor chambers 203, 303, and 609, respectively, all with such conventional internal components as susceptors, control plates, inlets, and exhausts. However, it should be understood that, with respect to all the figures, the illustrated function modules, the illustrated CVD reactor chambers, the illustrated features and components, and the like, are not limiting. Other embodiments that are not illustrated can include other function modules, other reactor chambers, other features and components, and so forth. The details of reactor chambers are not part of this invention, and beyond the description already provided in connection with Fig. 1, they are not further described. Also, the figures do not illustrate routine components, e.g., wiring, plugs and sockets, mechanical attachments, and so forth, that one or ordinary skill in the art would be readily able to provide and configure.

Preferred embodiments of the invention include heating function modules, and particularly heating function modules configured so that a single reactor enclosure can accommodate a number of different configurations of different heating function modules in a number of different arrangements. Accordingly, Figs. 2A-C illustrate a single reactor enclosure with three exemplary configurations of different numbers of different exemplary heating function modules.

Generally, Figs. 2A-C illustrate that heating elements are supported and held in independent modules, heating function modules, that can be readily by arranged and rearranged in a reactor enclosure. They also illustrate that heating function modules can have different numbers of heating elements, e.g., 2, 3, 4, 5, or 6 heating elements. Although heating elements are illustrated here as resembling linear, heating lamps, heating function modules can comprise other types of heating elements; a single heating function module can comprise different types, or combinations of types, of heating elements; and a single reactor can be configured with heating function modules having different types of heating elements. The types, numbers, and arrangements of heating function modules used along with a particular reactor enclosure are preferably selected to provide a profile of chamber heating suitable for the process to be conducted in an enclosed CVD reaction chamber. A single reactor enclosure can have different configurations and arrangements of heating function modules providing different heating profiles selected to be suitable for different processes that might be conducted in the chamber.

In more detail, Figs. 2A-B illustrate that upper (above the CVD reactor chamber) heating function modules are preferably oriented transversely to the long axis of the chamber (or to the direction of process gas flow), have a length comparable to the width of the chamber, and have a width that is only a portion of the length of the chamber. Heating elements can be arranged in heating function modules to accommodate features of individual heating elements; heating lamps can be either transversely or longitudinally oriented in transversely-oriented heating function modules, with a transverse orientation being preferred.

Fig. 2A schematically illustrates a reactor enclosure configured with four heating function modules, modules 221 a, 221 b, 221 c, and 221 d, all having four heating elements and being arranged above reactor chamber 203 in the upper portion of enclosure 201. The heating elements can be selected from known heating elements, e.g., heat lamps having filaments, LED arrays, and the like. The modules and their heating elements are all oriented transversely (both to gas flow and to the long axis of chamber 203). Optional equipment, e.g. longitudinal heating elements, can be present below reactor chamber 203, but such equipment is not illustrated in this figure. Each illustrated heating function module comprises: a housing, here represented in outline by dotted lines; fixtures, e.g., plugs, sockets, or the like (not illustrated), mounted on the housing for retaining heating elements; and four heating elements, e.g., heat lamps 215, illustrated with cross-hatching. Such necessary features as electrical cabling and the like are routine and therefore not illustrated.

Figs. 2B is like Fig. 2A except that two of the four heating function modules, modules 223a and 223b, have three heating elements, e.g., heat lamps 215, whilst the other two heating function modules, modules 223c and 223d, have four heating elements. This configuration is advantageous to provide a heating profile with increased heating to central regions of the reactor chamber, but lesser heating to regions upstream and downstream. Since longitudinal widths of all four heating function modules are substantially equal, the reactor enclosure can be configured with any combination of these three or four element modules in any arrangement along the longitudinal gas flow.

Fig. 2C illustrates that heating function modules can also be longitudinally oriented parallel to the long axis of the chamber (or to the direction of process gas flow), have a length comparable to the length of the chamber, and have a width that is only a portion of the width of the chamber. Preferably, lower (below the CVD reactor chamber) heating function modules are oriented along the long axis. In certain embodiments, lower heating elements may not be held in heating function modules but may be fixed to the reactor chamber. However, modularization of the lower (and upper) heating elements is advantageous in order to permit flexible positioning, e.g., positioning heating function modules around input and output fixtures; positioning heating function modules so as to complement the heating provided by upper heating function modules; positioning heating function modules so as to additionally heat the susceptor; positioning modules with additional functions along with heating function modules below the reactor chamber; and so forth.

In more detail, Fig. 2C illustrates a configuration with longitudinally-oriented heating function modules 225a and 225b placed below reactor chamber 203. Such equipment often is associated with precursor inlets or with the susceptor. Both modules have three longitudinally-oriented heating elements, e.g., heating lamps 227, extending between fixtures in the longitudinal ends of these modules (fixtures, wiring, and the like, not illustrated). Optional equipment, e.g. transverse heating elements, can be present above reactor chamber 203, but such equipment is not here illustrated. Modules 225a and 225b and are positioned to leave central, longitudinally-oriented region 217 free for other equipment, e.g., equipment associated with the susceptor, with gas entering the lower face of the reactor chamber, and so forth.

Preferred embodiments of this invention also include function modules of diverse types, including for example, modules that process precursors flowing into the reactor chamber, e.g., by applying energy to activate precursors such as by providing RF energy to create a plasma, or modules with no function that serve as placeholders in a configuration. As with heating function modules, the types, numbers, functions, and arrangements of such other modules used along with a particular reactor enclosure are preferably selected in view of the process to be conducted in an enclosed CVD reaction chamber.

Reactor sub-system configurations preferably include one or more metrology function modules having external sensors for characterization of internal chamber conditions and epilayer status during an ongoing CVD process. A metrology function module can be responsive to either a single parameter or to multiple parameters at either a single location or multiple nearby locations within a CVD reactor chamber. Multiple metrology function modules can be configured at different external locations to be sensitive to *in situ* parameters at more widely spaced locations within a reactor chamber. It is particularly pointed out that metrology function modules comprise sensors external to the chamber that observe conditions interior to a reactor chamber through the chamber's quartz transparent wall. The reactor chamber thereby does not need to be modified in any way to accommodate metrology function modules. The chamber's quartz transparent walls are preferably substantially planarized to prevent dispersion of the EM radiation probe. Metrology function modules can readily be rearranged, reconfigured, or replaced also with chamber modification.

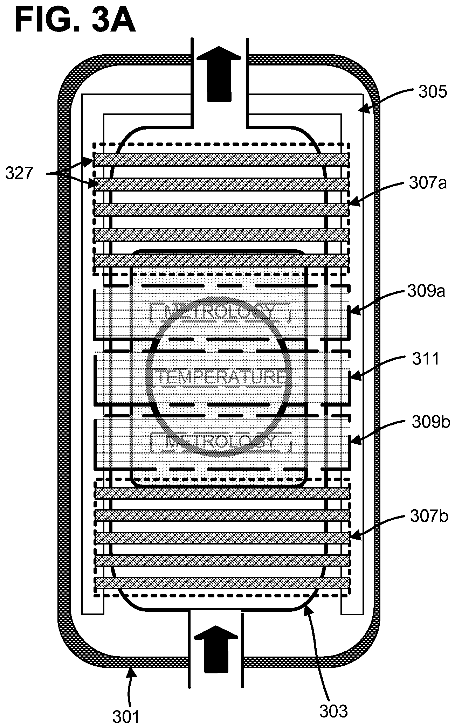

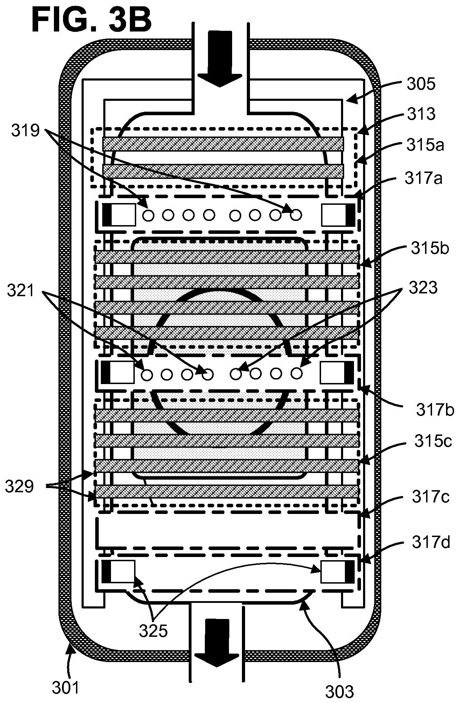

Figs. 3A-B illustrate a reactor enclosure with exemplary configurations including both metrology function modules and heating function modules. Although single function modules are illustrated here, function modules are not limited to providing a single function but can provide multiple different functions, e.g., a single function module can provide both heating and metrology functions to nearby portions of a CVD reactor chamber and interior. Fig. 3A illustrates a single metrology function module responsive primarily to temperature (e.g., module 311) and two metrology function modules responsive primarily to epilayer metrology parameters (e.g., modules 309a and 309b). Fig. 3B illustrates metrology function modules responsive to a single parameter (e.g., module 317d), responsive to two parameters (e.g., module 317a), and responsive to three parameters (e.g., module 317b). Also, module 317a has sensors 319 responsive to a distribution of a single parameter across the width of the reactor chamber. Metrology function modules are usually configured above the reactor chamber since parameters at and above the epilayer are usually most useful. Alternatively, they can be configured below the reactor chamber.

More specifically, Fig. 3A illustrates a reactor enclosure of this disclosure configured with two transversely-oriented heating function modules 307a and 307b and three transversely-oriented metrology function modules 309a, 311, and 309b. The two heating function modules can be similar to the heating function modules described in connection with Figs. 2A-B. The three metrology function modules are mounted above the susceptor (or the central region of the reactor chamber) so as to be responsive to conditions at or near an epilayer supported on the susceptor. For concreteness this figure illustrates more central module 311 primarily responsive to temperature with two adjacent, more-peripheral modules 309a and 309b primarily responsive to other metrology functions, e.g., thickness and roughness of the epilayer. The metrology function modules (like other function modules) comprise housings indicated here with dashed lines (housing of the heating function modules being again indicated dotted lines).

Fig. 3B illustrates another of the possible configurations of modules. As compared to Fig. 3A, two more-peripheral metrology function modules have been rearranged upstream and downstream of the susceptor: metrology function module 317a has been arranged near the inlet to the reactor chamber to sense conditions prior to reaction at the growing epilayer; and metrology function module 317d has been arranged near the exhaust to sense conditions subsequent to reaction at the epilayer. Metrology function module 317b remains over the susceptor in order to sense conditions at the growing epilayer and the susceptor. Although limited in longitudinal extent compared to the susceptor, central module 317b can actually measure conditions across the entire susceptor (and epilayer) surface because the susceptor rotates during operation. As further compared to Fig. 3A, space for this alternative metrology-module configuration above the reactor chamber's upper face is made available by replacing the two five-element heating function modules used in that prior configuration with one two-element and two four element heating function modules used in the present configuration.

Module 317c is an empty module without function, or at least without function being used in the current configuration. It functions only as a space-filler since it is desired in this arrangement that the portions of the reactor downstream of the susceptor be less intensely heated. Such a space-filler module can also serve as a placeholder that can assist in retaining other function modules in their planned positions.

In preferred embodiments of this invention, independent function modules and the reactor enclosures are structured and sized to cooperate together so that a reactor enclosure can accommodate different configurations and arrangements of function modules and so that a function module can be used in different configurations and arrangements, and optionally, with different reactor enclosures. Such ability to interchange function modules with each other and also the ability to use a function module with different reactor enclosures provides flexibility and economy. A single reactor sub-system of this disclosure (e.g., a reactor enclosure with a CVD reactor chamber and function modules) can be flexibly tailored to the needs of different CVD processes conducted within the chamber, allowing reuse and reconfiguration of existing reactor sub-systems instead of purchase of new reactor sub-systems.

Preferred heating function modules are described next in more detail, and following, preferred metrology function modules and sensors are then described. Lastly, preferred reactor enclosures are described in more detail.

Turning first to features of preferred function modules, ready reconfiguration or rearrangement of function modules is promoted by designing function modules in certain standard sizes and with reusable mounting means permitting removal and replacement. In an exemplary embodiment, function module sizes can be chosen to be approximately simple fractions of relevant sizes of the reactor chamber or of the reactor enclosure. The term "simple fraction" includes such fractions as one-half, one-third, one-quarter, one-sixth, and the like, along with their small integer multiples, e.g., two-thirds, three-quarters, and the like. Transversely oriented function modules with longitudinal widths selected as such simple fractions of the length of the reactor enclosure can be readily arranged along the length of a reactor enclosure. For example, one module of width one-half can readily be arranged along with two modules of width one-quarter, and so forth. Similarly, longitudinally oriented function modules with transverse widths selected as such simple fractions of the width of the reactor enclosure can be readily rearranged across the width of a reactor enclosure.

For example, Fig. 2A illustrates four transversely oriented heating function modules, modules 221 a-d, each having a width of approximately one-quarter the length of enclosed CVD reactor chamber 203. It is apparent that any or all of these modules could be readily rearranged, or could also be readily replaced by other function modules that have a width also of approximately one-quarter the chamber length. Further, one or these quarter-width function modules could be replaced by two function modules having a width of approximately one-eighth the chamber or enclosure length; or two such quarter-width function modules could be replaced by a single modules having a width of approximately one-half the chamber or enclosure length.

Similarly, Fig. 2C illustrates two longitudinally oriented heating function modules, modules 225a-b, each having a width of approximately one-third the width of enclosed CVD reactor chamber 203. These two modules leave unoccupied longitudinally oriented region 217 that is also approximately one-third the width of the reactor chamber. It is apparent that any or all of these modules and unoccupied region could be readily rearranged, or could also be readily replaced by other function modules (with a heating or other function) or unoccupied regions that are also of approximately one-third the chamber width (or of a related width).

Function modules are also preferably configured with mounting means which permit the modules to be readily placed and held in a reactor enclosure, and rearranged in the enclosure, removed from the enclosure, and the like. Such mounting means can include screws, clips, and so forth as are well known in the arts. Such mounting means can also include ledges, ridges, guides, and so forth as are also well known in the art, and that possibly mate with corresponding structures formed in a reactor enclosure so as to support the function modules. Much less preferably, one or more function modules can be semi-permanently or permanently secured in an enclosure by, e.g., spot welds, bolts, and so forth. Such mounting reduces the ability to readily reconfigure or rearrange the function modules in a reactor enclosure.

Figs. 3A-B also illustrate that function modules can be mounted by placing them on a separate support member 305 in the reactor enclosure. Function modules can be retained in position on such a support member by their weight alone, and so forth, or alternatively, the support member can include surface features that guide the function modules in one of several pre-selected positions. The support member can be structured and sized so that function modules can also be positioned below the reactor chamber, above the reactor chamber, or both. The support member can comprise the same materials as used in the reactor enclosure, or as used in the reactor chamber, or other materials. Illustrated support member 305 has a U-shape, but alternative support members can have a rectangular shape, or can comprise parallel, separate support bars running along the edges of the reactor enclosure.

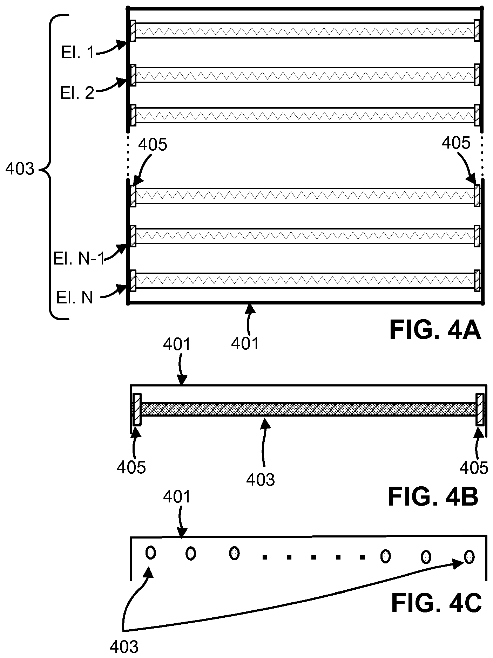

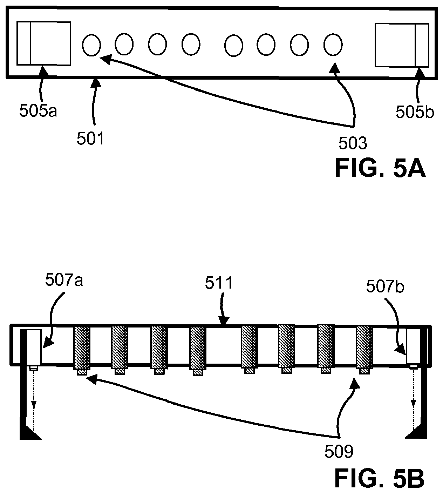

Next, additional and more specific features of function modules are illustrated with reference to Figs. 4A-C (illustrating exemplary heating function modules) and Figs. 5A-B (illustrating exemplary metrology function modules). Generally, these figures illustrate that function modules can comprise functional components, e.g., heating elements, sensors, and the like, and a housing with means for supporting and retaining functional components. Although function modules housings are structured and sized to cooperate as described with one or more reactor enclosures, modules housings are structurally independent of, and not integral to, the reactor enclosure. For example, they can be separately and individually removed and replaced without modification of the reactor enclosure. Housings are schematically illustrated here by dark solid lines, and are also schematically illustrated in Figs. 2A-C by short-dashed lines, and in Figs. 3A-B by short-dashed and long-dashed lines. Means for supporting and retaining functional components usually depend on the specifics of the individual functional components.

Fig. 4A illustrates a plan view of exemplary heating function module 401; Figs. 4B-C illustrate transverse and longitudinal sections, respectively, of this module. Module 401 comprises a housing, illustrated by bold dark line, and heating element fixtures 405, e.g., plugs, sockets, or the like, as are known in the art, for supporting, retaining, and making electrical connections to the heating elements. Each such heating function modules can be configured with one or more heating elements 403. Here, module 401 is illustrated as fully populated with N heating elements, elements El. 1, El. 2, ... El. N-1, and El. N. Radiative heating elements can include conventional resistive filaments (as suggested here) or can also include solid state elements (see, e.g., US 7,173,216), or other active components.

Fig. 5A illustrates in more detail a plan view and a transverse section of an exemplary, transversely-oriented metrology function module. Generally, metrology function modules comprise housings, retaining means for one or more sensors, and one or more sensors. Metrology function modules can have a fixed configuration, supporting and retaining a fixed number of pre-selected sensors in a fixed arrangement, or can have a modular, flexible configuration, supporting and retaining a variable number of differing sensors in a variable arrangement. Sensor retaining means can provide for fixed sensors of pre-selected types, or can permit sensors of different types to be removed and replaced (e.g., during routine maintenance). Sensors can be configured into a single sensor-housing or package (a single-component sensor), or can be configured into two separate sensor-housings or packages (two-component sensors), or can be of other types. Typically, single component sensors include temperature sensors, reflectivity sensors, and the like; two component sensors include sensors of gas composition, sensors of reactor chamber wall deposits, and the like.

The illustrated metrology function module has housing 501 (schematically illustrated by a bold dark line), a plurality of retaining means 503 for retaining single component sensors, and a single retaining means 505a and 505b for retaining a two component sensor. The numbers and types of retaining means illustrated here are illustrative. This module is not yet populated with any sensors. Fig. 5B illustrates in section view metrology function module 511 that is similar to the module of Fig. 5A except for being fully populated with actual sensors. Plural retaining means for single-component sensors here secure and retain single-component sensors 509 which can be of the same or of different types in any arrangement. A single retaining means comprising two separated pieces (505a and 505b in Fig. 5A) here secures and retains a single two-component sensor having components 507a and 507b.

Additional details of metrology function modules have been illustrated in Figs. 3A-B with respect to metrology modules 317a, 317b, and 317d. Here, icons 319, 321, and 323 represent means for mounting single-component sensors and icons 325 represent means for mounting two-component sensors. Metrology function module 317a has been tailored for measuring properties of incoming precursor gases by populating a housing with a two-component gas composition sensor and a number of single-component temperature sensors 319. Metrology function module 317d have been tailored for measuring properties of exhaust gases by populating a same or a different housing with only a two-component gas composition sensor. Metrology function module 317b has been tailored for measuring properties at the susceptor by populating a further housing with a two-component gas composition sensor, a number of single-component temperature sensors 321, and a number of single-component reflectivity sensors 323.

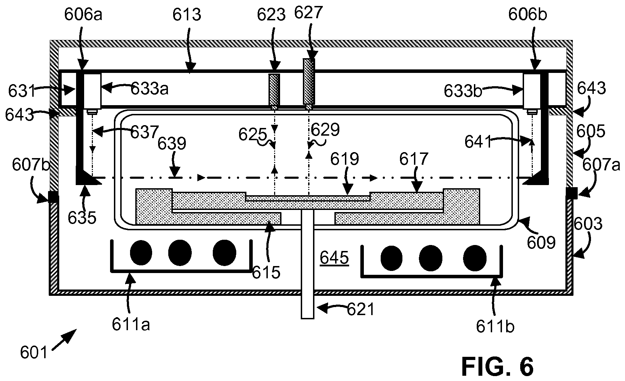

Metrology function modules preferably comprise one or more sensors responsive to temperature, sensors responsive to radiation reflected from within the chamber, and sensors responsive to gas composition within the chamber. Although these preferred sensors are important for semiconductor processes, the invention is not limited to these sensors types. One of ordinary skill in the art will know of other useful sensors, and in view of the description herein, will be able to use such other sensors in metrology function modules of this disclosure. Operation and utility of the preferred sensors are now described with reference in particular to Fig. 6.

Considering first temperature sensors, these sensors are generally useful and advantageous for controlling temperatures during CVD processes so that higher quality product can be produced. However, many current temperature sensors, especially those that rely on thermocouples (TC) situated in a reactor chamber below and in the region of the wafer, have known disadvantages including, e.g., slow response times, since they respond only to slowly conducted heat, and limited reliabilities, since they are internal to the chamber and exposed to the harsh interior conditions.

Instead, temperature sensors of this disclosure are external to the CVD chamber and responsive to thermal radiation passing through the walls of the chamber. They, thereby have high reliability and rapid response time. More specifically, preferred temperature sensors, e.g., sensor 627 (Fig. 6), are single component sensors comprising a pyrometer that measures the temperature of a surface, e.g., an epilayer, inside the reactor chamber by being responsive to thermal radiation 629 emitted from the surface (the reactor chamber walls quartz being sufficiently transparent to the relevant thermal radiation). Temperature sensors of this disclosure being mounted on metrology function modules, can be readily arranged to measure temperatures at various locations within a reactor chamber.

Considering next reflection sensors, radiation reflected from a growing epilayer carries information concerning, e.g., the epilayer's thickness and surface roughness. Thereby, reflection sensors that are responsive to radiation reflected from the growing epilayer to the outside of a CVD chamber can provide thickness and roughness information. Thickness information can indicate the epilayer's growth rate, and roughness information can indicate the nature of the growth processes. For example, certain materials, e.g., GaN, can grow in both a 3D growth mode resulting in an irregular surface with lower reflection, or in a 2D step-flow growth mode resulting in a substantially smooth surface with a higher reflection. Reflectivity information can accordingly be used for control of GaN and similar processes so as to achieve higher quality product. Such sensors can also be used for development of new or modified processes.

Reflectivity sensors of this invention, e.g., single component sensor 623, are selected to measure optical properties of radiation, e.g., radiation 625, that has been reflected from surfaces within a reactor chamber, the incident radiation preferably originating at least in part from a source associated with the sensor. Such sensors can be responsive to visible radiation, and can include a light source focused on a surface and a probe with a fiber-optic bundle. As with other sensors, reflectivity sensors are mounted on metrology function modules so that they are not exposed to the harsh conditions within chamber and can be flexibly arranged with respect to the CVD reactor chamber.

Finally, considering gas composition sensors, knowledge of gas composition within the reactor chamber is useful and advantageous for several purposes. For example, knowledge of the composition of gases reacting at the surface of the epilayer during the course of a CVD process can be used for improved control of precursor gas flow rates. Also, knowledge of the composition of gases exiting a chamber during chamber cleaning can be used to automatically monitor gas-phase cleaning of unwanted residues from a chamber interior. However, gas composition has been difficult to measure accurately. Because of the difficulty of directly and reliably measuring gas composition using sensors internal to a reactor chamber, gas composition has, heretofore, usually been estimated from chamber temperatures and precursor flow rates. Such estimations are not accurate, and further, cannot measure changes in gas composition at different locations within the chamber.

Sensors of this disclosure overcome such disadvantages since they are external to a reactor chamber, can directly measure gas composition at one or more separate locations within the chamber, and can be readily rearranged as they are preferably mounted on metrology function modules. Preferably, these sensors operate by determining gas composition from the absorption and spectral properties of light after passing though the chamber using methods known in the art. Briefly, light absorption is related to the absorptive coefficients and concentrations of the different absorbers (e.g., gas components) as prescribed by the Beer-Lambert Law, and absorptive coefficients vary with light frequency in a manner characteristic of each absorber. Determination of gas composition can be calibrated for a particular gas composition sensor and reactor chamber by making measurements of gases of known composition.

Preferred embodiments of gas composition sensors usually include two components external to the chamber: a first component for transmitting a visible and/or ultraviolet (UV-vis) light beam having known spectral properties through the reactor chamber; and a second component for receiving the transmitted light beam and for measuring its spectral properties. Multiple gas composition sensors can be provided to measure composition at multiple positions within a reactor chamber. For example, one such sensor can be positioned and arranged to measure gas composition in the vicinity of a growing epilayer; another sensor can be positioned and arranged near the precursor gas entry and spent gas exhaust to fully assesses the environment within the reactor.

Although not illustrated, function modules are not limited to providing a single function. Rather function modules of the disclosure can be multi-function modules that provide multiple different functions or multiple types of a single function to nearby portions of a CVD reactor chamber and interior. For example, a single heating function module can include different types of heating elements, e.g., one or more resistive elements, one or more radiant heat lamps, and one or more and radiant semiconductor elements. A single metrology function module can include different types of sensor elements, e.g., a gas composition sensor, a surface properties sensor, and a temperature sensor. Further, a single independent function module can include function elements of different types, e.g., heating function elements and sensor function elements. Such a multi-function module could include radiant heating lamps and a gas composition sensor.

Fig. 6 illustrates a preferred embodiment of such a spectral gas composition sensor of this disclosure comprising a left portion, component 606a, and right portion, component 606b. Both components are supported and retained by metrology function module housing 613 at the sides of reactor chamber 609 so that they are separated by an unobstructed path through at least part of the chamber. Both components comprise support members 631, which can be, e.g., substantially similar to each other (perhaps mirror images of each other). Left component 606 also comprises a focused UV-vis light source 633a, for emitting light beam 637, and an angled reflector 635, for reflecting beam 637 into beam 639 passing through the chamber. Right component 606b also comprises another angled reflector, for reflecting beam 639 after it has passed through the chamber into beam 641 directed to sensor 633b, and spectrally-sensitive sensor 633b. Sensor 633b can be in one piece as illustrated, or alternatively can be a probe receiving beam 641 and conveying it to a remote light sensor via, e.g., optical fibers.

Turning next to reactor enclosures, preferred features are now described with reference to Fig. 6. Generally, reactor enclosures of this disclosure are structured and sized to hold and retain a reactor chamber preferably of one or more types and preferably in a manner permitted the chamber's removal and replacement, and also to permit ready configuration and arrangement of function modules, such as the function modules illustrated in Fig. 4A-C and Figs. 5A-B. An exemplary embodiment of a reactor enclosure of the disclosure can comprise upper and lower portions which can be readily separated (e.g., during routine maintenance) to provide access to the interior of the reactor enclosure, e.g., to the reactor chamber, to the function modules, and to other equipment. For example, the upper and lower portions can be hingedly joined so that they can swing away from each other. Upper portions preferably support and retain function modules in a manner permitting the modules' ready reconfiguration and rearrangement. Lower portions also preferably support and retain reconfigurable and re-arrangeable function modules (or other equipment), but less preferably have only fixedly attached function modules.

In more detail, exemplary reactor enclosure 601 is illustrated in transverse section at the level of the susceptor. The section illustrates upper portion 605 and lower portion 603 of reactor enclosure 601, and also includes sections of transversely-oriented upper metrology function module 613, reactor chamber 609 (with internal components), and two longitudinally oriented lower heating function modules 611a and 611b. The upper and lower portions of reactor enclosure 601 are reversibly secured together by means 607a and 607b, and preferably can be readily separated to provide access to the reactor-enclosure interior and to the CVD reactor chamber and function modules supported therein. For example, means 607a could function as a hinge, and means 607b could function as a latch (or vice versa). The reactor chamber 609 preferably has quartz walls and includes such standard internal components as susceptor control ring 615, susceptor 617, wafer holder 619, and susceptor shaft 621. The susceptor shaft is usually controllably rotated by equipment (not illustrated), which can reside in gap 645 between longitudinally-oriented heating function modules 611a and 611b.

The two longitudinally oriented heating function modules, similarly to modules 225a and 25b of Fig. 2C, comprise a housing and three longitudinally-oriented heating elements. The heating function modules can extend under some or all of reactor chamber 609, and can be supported and retained at their longitudinal ends by lower portion 603 of the housing (not illustrated) or be supported on a ledge, or insert (as illustrated in Figs.3A-B), or the like. The heating function modules can be structured as in Figs. 4A-B with heating elements extending between fixtures on the modules housings. The transverse width of the heating function is preferably, as previously described, a simple fraction of the reactor chamber width. Here, the heating function modules extend transversely for approximately one-third of the reactor chamber width leaving centrally-located gap 645, also approximately one-third of the width.

Transversely oriented metrology function modules 613 can be structured as in Figs. 5A-C with a housing, sensor retaining means, single component sensors 623 and 627, and two-component sensor 606a and 606b, and can to be supported, e.g., on ledge-like members 643 extending from the transverse sides of upper portion 605 of the reactor enclosure. The transverse length of the metrology function module is preferably approximately as large as or larger that the width of the reactor chamber, while the longitudinal width is preferably, as previously described, a simple fraction of the reactor chamber length. Two component sensor 606a and 606b represents a gas composition sensor. Sensor 623 represents a reflectivity sensor, and sensor 605 a temperature sensor.

The preferred embodiments of the invention described above do not limit the scope of the invention, since these embodiments are illustrations of several preferred aspects of the invention. Indeed, various modifications of the invention in addition to those shown and described herein, such as alternate useful combinations of the elements described, will become apparent to those skilled in the art from the subsequent description. In the following (and in the application as a whole), headings and legends are used for clarity and convenience only.

Although specific features of the invention are shown in some drawings and not in others, this is for convenience only as each feature may be combined with any or all of the other features in accordance with the invention. The words "including", "comprising", "having", and "with" as used herein are to be interpreted broadly and comprehensively and are not limited to any physical interconnection. The articles "a" or "an" or the like are also to be interpreted broadly and comprehensively as referring to both the singular and the plural. Moreover, any embodiments disclosed in the subject application are not to be taken as the only possible embodiments.

## Claims

1. A modular chemical vapor deposition (CVD) reactor sub-system comprising:
a modular reactor enclosure (201, 301, 601);
a CVD reactor chamber (203, 303, 609) supported by the reactor enclosure; and
a plurality of independent function modules (221a-221d, 223a-223d, 225a-225b, 307a, 307b, 309a, 309b, 311, 315a-315c, 317a-317d, 319, 611a, 611b) supported by the reactor enclosure adjacent to the exterior walls of the CVD reactor chamber but otherwise structurally independent of the reactor enclosure, each function module providing one or more functions to nearby portions of the CVD reactor chamber and its interior that are useful to processes carried out within the CVD reactor chamber;
wherein function modules include one or more metrology function modules (309a, 309b, 311, 315a-315c, 317a-317d, 319, 613) for measuring selected conditions in the interior of the CVD reactor chamber, and
wherein the independent function modules are interchangeable with each other.

2. The reactor sub-system of claim 1 wherein the reactor enclosure and the function modules are mutually configured and sized so that at least one function module can be supported by the reactor enclosure at a plurality of different positions adjacent to the exterior walls of the reactor chamber.

3. The reactor sub-system of claim 1 wherein at least one function module comprises a longer dimension oriented in a direction perpendicular to gas flow within the chamber, and a shorter dimension in direction parallel to process gas flow.

4. The reactor sub-system of claim 1 wherein each function module further comprises:
at least one housing that is structurally independent of and removable from the reactor enclosure; and
one or more function elements supported by the function module housing for providing the functions performed by the module.

5. The reactor sub-system of claim 4 wherein one or more function modules further comprise heating elements supported by the module housings for providing heat to nearby portions of the CVD reactor chamber and its interior.

6. The reactor sub-system of claim 5 wherein the heating function modules further comprise one or more radiant heating elements emitting radiation to which the walls of the reactor chamber are at least partially transparent.

7. The reactor sub-system of claim 5 further comprising a plurality of heating function that are supported by the reactor enclosure so as to provide a profile of heat of the CVD reactor chamber interior.

8. The reactor sub-system of claim 4 wherein one or more metrology function modules further comprise one or more sensors supported by the module housings for measuring conditions nearby portions of the CVD reactor chamber and its interior.

9. The reactor sub-system of claim 8 wherein the sensors further comprise one or more of a sensor for determining composition of gases internal to the CVD reactor chamber by measuring the spectral properties of light transmitted through gases, a sensor for determining temperatures internal to the CVD reactor chamber by measuring radiation emitted from within the reactor chamber, a sensor for determining the thickness of a surface within the reactor chamber by measuring radiation reflected from the surface, and a sensor for determining the roughness of a surface within the reactor chamber by measuring radiation reflected from the surface.

10. The reactor sub-system of claim 8 further comprising a plurality of metrology function modules that are supported by the reactor enclosure so as to measure conditions in a plurality of different portions of the CVD reactor chamber interior.

11. A method for configuring a modular CVD reactor sub-system comprising a modular reactor enclosure supporting a CVD reactor chamber and a plurality of independent function modules, the independent function modules being supported by the reactor enclosure adjacent to the exterior walls of the CVD reactor chamber but otherwise structurally independent of the reactor enclosure, each independent function module providing one or more functions to nearby portions of the CVD reactor chamber and its interior that are useful to processes carried out within the CVD reactor chamber, the method comprising:
selecting one or more independent function modules;
for each selected function module, selecting a corresponding portion of the CVD chamber and its interior;
removing any function modules that are supported by the reactor enclosure nearby to selected portions of the CVD reactor chamber and its interior; and
supporting each selected function module on the reactor enclosure adjacent to the exterior walls of the CVD reactor chamber that are nearby to the corresponding portion of the CVD reactor chamber and its interior selected for that function module;
wherein the selected function modules further comprise one or more sensors for measuring conditions in nearby portions of the CVD reactor chamber and its interior, or one or more metrology function modules for measuring selected conditions in the interior of the CVD reactor chamber; and
wherein the independent function modules are interchangeable with each other.

12. The method of claim 11 wherein the selected function modules further comprises one or more heating function modules for providing heat to the CVD reactor chamber and its interior and wherein a function module already supported by the reactor enclosure nearby to a selected portion is removed if it provides a function similar to the function provided by the selected module to be mounted at that selected portion.

13. The method of claim 12 wherein, for each selected heating function module, a corresponding portion of the CVD reactor chamber and its interior are selected so that, when the selected heating function module is supported nearby to the corresponding portion, heat is provided by the heating function modules to the CVD reactor chamber and its interior according to a preferred heating profile determined in dependence on a particular CVD process to be performed.

14. The method of claim 13 wherein, for each selected metrology function module, a corresponding portion of the CVD reactor chamber and its interior are selected so that, when the selected metrology function module is supported nearby to the corresponding portion, measurements of the interior of the CVD reactor chamber are made according to a preferred measurement profile determined in dependence on a particular CVD process to be performed.

## Patentansprüche

1. Modulares CVD-Reaktor-Teilsystem (chemical vapour deposition reactor sub-system), das umfasst:
eine modulare Reaktor-Ummantelung (201, 301, 601);
eine CVD-Reaktor-Kammer (203, 303, 609), die von der Reaktor-Ummantelung aufgenommen wird; sowie
eine Vielzahl unabhängiger Funktions-Module (221 a-221 d, 223a-223d, 225a-225b, 307a, 307b, 309a, 309b, 311, 315a-315c, 317a-317d, 319, 611 a, 611b), die von der Reaktor-Ummantelung an die Außenwände der CVD-Reaktor-Kammer angrenzend aufgenommen werden, ansonsten jedoch strukturell unabhängig von der Reaktor-Ummantelung sind, wobei jedes Funktions-Modul nahegelegenen Abschnitten der CVD-Reaktor-Kammer und ihres Innenraums eine oder mehrere Funktion/en verleiht, die nützlich für Prozesse ist/sind, die im Inneren der CVD-Reaktor-Kammer ausgeführt werden,
wobei Funktions-Module ein oder mehrere Mess-Funktions-Module (309a, 309b, 311, 315a-315c, 317a-317d, 319, 613) zum Messen ausgewählter Bedingungen in dem Innenraum der CVD-Reaktor-Kammer einschließen, und
die unabhängigen Funktions-Module gegeneinander ausgetauscht werden können.

2. Reaktor-Teilsystem nach Anspruch 1, wobei die Reaktor-Ummantelung und die Funktions-Module zueinander so ausgeführt und dimensioniert sind, dass wenigstens ein Funktions-Modul von der Reaktor-Ummantelung an einer Vielzahl unterschiedlicher Positionen aufgenommen werden kann, die an die Außenwände der Reaktor-Kammer angrenzen.

3. Reaktor-Teilsystem nach Anspruch 1, wobei wenigstens ein Funktions-Modul eine längere Abmessung, die in einer Richtung senkrecht zu Gasstrom im Inneren der Kammer ausgerichtet ist, und eine kürzere Abmessung in einer Richtung parallel zu Prozess-Gasstrom umfasst.

4. Reaktor-Teilsystem nach Anspruch 1, wobei jedes Funktions-Modul des Weiteren umfasst:
wenigstens ein Gehäuse, das strukturell unabhängig von der Reaktor-Ummantelung ist und von ihr entfernt werden kann; sowie
ein oder mehrere Funktions-Element/e, das/die von dem Funktions-Modul-Gehäuse aufgenommen wird/werden, um die von dem Modul durchgeführten Funktionen zu ermöglichen.

5. Reaktor-Teilsystem nach Anspruch 4, wobei ein oder mehrere Funktions-Modul/e des Weiteren Erwärmungs-Elemente umfasst/umfassen, die von den Modul-Gehäusen aufgenommen werden, um nahegelegenen Abschnitten der CVD-Reaktor-Kammer und ihres Innenraums Wärme zuzuführen.

6. Reaktor-Teilsystem nach Anspruch 5, wobei die Erwärmungs-Funktions-Module des Weiteren ein oder mehrere Strahlungs-Erwärmungs-Elemente umfassen, die Strahlung emittieren, für die die Wände der Reaktor-Kammer wenigstens teilweise durchlässig sind.

7. Reaktor-Teilsystem nach Anspruch 5, das des Weiteren eine Vielzahl von Erwärmungs-Funktions-Modulen umfasst, die von der Reaktor-Ummantelung aufgenommen werden, um dem Innenraum der CVD-Reaktor-Kammer ein Wärme-Profil zu verleihen.

8. Reaktor-Teilsystem nach Anspruch 4, wobei ein oder mehrere Mess-Funktions-Modul/e des Weiteren einen oder mehrere Sensor/en umfasst/umfassen, der/die von den Modul-Gehäusen aufgenommen wird/werden, um Bedingungen nahegelegener Abschnitte der CVD-Reaktor-Kammer und ihres Innenraums zu messen.

9. Reaktor-Teilsystem nach Anspruch 8, wobei die Sensoren des Weiteren einen Sensor, mit dem Zusammensetzung von Gasen im Inneren der CVD-Reaktor-Kammer bestimmt wird, indem die Spektraleigenschaften von Licht gemessen werden, das durch Gase durchgelassen wird, einen Sensor, mit dem Temperaturen im Inneren der CVD-Reaktor-Kammer bestimmt werden, indem aus dem Inneren der Reaktor-Kammer emittierte Strahlung gemessen wird, einen Sensor, mit dem die Dicke einer Oberfläche im Inneren der Reaktor-Kammer bestimmt wird, indem von der Oberfläche reflektierte Strahlung gemessen wird, oder/und einen Sensor umfassen, mit dem die Rauigkeit einer Oberfläche im Inneren der Reaktor-Kammer bestimmt wird, indem von der Oberfläche reflektierte Strahlung gemessen wird.

10. Reaktor-Teilsystem nach Anspruch 8, das des Weiteren eine Vielzahl von Mess-Funktions-Modulen umfasst, die von der Reaktor-Ummantelung aufgenommen werden, um Bedingungen in einer Vielzahl unterschiedlicher Abschnitte des Innenraums der CVD-Reaktor-Kammer zu messen.

11. Verfahren zum Konfigurieren eines modularen CVD-Reaktor-Teilsystems, das eine modulare Reaktor-Ummantelung, die eine CVD-Reaktor-Kammer aufnimmt, und eine Vielzahl unabhängiger Funktions-Module umfasst, wobei die unabhängigen Funktions-Module von der Reaktor-Ummantelung an die Außenwände der CVD-Reaktor-Kammer angrenzend aufgenommen werden, ansonsten jedoch strukturell unabhängig von der Reaktor-Ummantelung sind, und jedes unabhängige Funktions-Modul nahegelegenen Abschnitten der CVD-Reaktor-Kammer und ihres Innenraums eine oder mehrere Funktion/en verleiht, die nützlich für Prozesse ist/sind, die im Inneren der CVD-Reaktor-Kammer ausgeführt werden, wobei das Verfahren umfasst:
Auswählen eines oder mehrerer unabhängigen/unabhängiger Funktions-Moduls/Funktions-Module;
Auswählen eines entsprechenden Abschnitts der CVD-Kammer und ihres Innenraums für jedes ausgewählte Funktions-Modul;
Entfernen etwaiger Funktions-Module, die von der Reaktor-Ummantelung in der Nähe ausgewählter Abschnitte der CVD-Reaktor-Kammer und ihres Innenraums aufgenommen werden; und
Aufnehmen jedes ausgewählten Funktions-Moduls in der Reaktor-Ummantelung an die Außenwände der CVD-Reaktor-Kammer angrenzend, die nahe an dem entsprechenden, für dieses Funktions-Modul ausgewählten Abschnitt der CVD-Reaktor-Kammer und ihres Innenraums liegen;
wobei die ausgewählten Funktions-Module des Weiteren einen oder mehrere Sensor/en zum Messen von Bedingungen in nahegelegenen Abschnitten der CVD-Reaktor-Kammer und ihres Innenraums oder ein oder mehrere Mess-Funktions-Modul/e zum Messen ausgewählter Bedingungen in dem Innenraum der CVD-Reaktor-Kammer umfassen; und
die unabhängigen Funktions-Module gegeneinander ausgetauscht werden können.

12. Verfahren nach Anspruch 11, wobei die ausgewählten Funktions-Module des Weiteren ein oder mehrere Erwärmungs-Funktions-Modul/e umfassen, mit dem/denen der CVD-Reaktor-Kammer und ihrem Innenraum Wärme zugeführt wird, und ein bereits von der Reaktor-Ummantelung in der Nähe eines ausgewählten Abschnitts aufgenommenes Funktions-Modul entfernt wird, wenn es eine Funktion erfüllt, die der Funktion gleicht, die durch das an diesem ausgewählten Abschnitt zu installierende ausgewählte Modul erfüllt wird.

13. Verfahren nach Anspruch 12, wobei für jedes ausgewählte Erwärmungs-Funktions-Modul ein entsprechender Abschnitt der CVD-Reaktor-Kammer und ihres Innenraums so ausgewählt wird, dass, wenn das ausgewählte Erwärmungs-Funktions-Modul in der Nähe des entsprechenden Abschnitts aufgenommen wird, Wärme durch die Erwärmungs-Funktions-Module der CVD-Reaktor-Kammer und ihrem Innenraum entsprechend einem bevorzugten Erwärmungs-Profil zugeführt wird, dass in Abhängigkeit von einem speziellen durchzuführenden CVD-Prozess bestimmt wird.

14. Verfahren nach Anspruch 13, wobei für jedes ausgewählte Mess-Funktions-Modul ein entsprechender Abschnitt der CVD-Reaktor-Kammer und ihres Innenraums so ausgewählt wird, dass, wenn das ausgewählte Mess-Funktions-Modul in der Nähe des entsprechenden Abschnitts aufgenommen wird, Messungen des Innenraums der CVD-Reaktor-Kammer entsprechend einem bevorzugten Mess-Profil vorgenommen werden, dass in Abhängigkeit von einem speziellen durchzuführenden CVD-Prozess bestimmt wird.

## Revendications

1. Sous-système de réacteur modulaire de dépôt chimique en phase vapeur (CVD) comprenant :
une enceinte de réacteur modulaire (201, 301, 601) ;
une chambre de réacteur CVD (203, 303, 609) supportée par l'enceinte du réacteur ; et
une pluralité de modules de fonction indépendants (221a-221d, 223a-223d, 225a-225b, 307a, 307b, 309a, 309b, 311, 315a-315c, 317a-317d, 319, 611a, 611b) supportés par l'enceinte du réacteur adjacente aux parois extérieures de la chambre du réacteur CVD mais autrement structurellement indépendants de l'enceinte du réacteur, chaque module de fonction fournissant une ou plusieurs fonctions à des portions proches de la chambre du réacteur CVD et à son intérieur qui sont utiles à des processus mis en oeuvre dans la chambre du réacteur CVD ;
dans lequel des modules de fonction incluent un ou plusieurs modules de fonction métrologiques (309a, 309b, 311, 315a-315c, 317a-317d, 319, 613) pour mesurer des conditions sélectionnées à l'intérieur de la chambre du réacteur CVD, et
dans lequel les modules de fonction indépendants sont interchangeables.

2. Sous-système de réacteur selon la revendication 1, dans lequel l'enceinte du réacteur et les modules de fonction sont configurés mutuellement et dimensionnés de telle sorte qu'au moins un module de fonction peut être supporté par l'enceinte du réacteur à une pluralité de positions différentes adjacentes aux parois extérieures de la chambre du réacteur.

3. Sous-système de réacteur selon la revendication 1, dans lequel au moins un module de fonction comprend une dimension plus grande en direction perpendiculaire au flux gazeux dans la chambre, et une dimension plus courte en direction parallèle au flux gazeux du processus.

4. Sous-système de réacteur selon la revendication 1, dans lequel chaque module de fonction comprend en outre :
au moins un boîtier qui est structurellement indépendant et amovible de l'enceinte du réacteur ; et
un ou plusieurs éléments fonctionnels supportés par le boîtier du module de fonction pour fournir les fonctions mises en oeuvre par le module.

5. Sous-système de réacteur selon la revendication 4, dans lequel un ou plusieurs modules de fonction comprennent en outre des éléments de chauffage supportés par les boîtiers de module pour fournir de la chaleur à des portions proches de la chambre du réacteur CVD et de son intérieur.

6. Sous-système de réacteur selon la revendication 5, dans lequel les modules de fonction de chauffage comprennent en outre un ou plusieurs éléments de chauffage radiant émettant une radiation à laquelle les parois de la chambre du réacteur sont au moins partiellement transparentes.

7. Sous-système de réacteur selon la revendication 5, comprenant en outre une pluralité de fonctions de chauffage qui sont supportées par l'enceinte du réacteur de manière à fournir un profil de chaleur de l'intérieur de la chambre du réacteur CVD.

8. Sous-système de réacteur selon la revendication 4, dans lequel un ou plusieurs modules de fonction métrologiques comprennent en outre un ou plusieurs capteurs supportés par les boîtiers de module pour mesurer les conditions de portions proches de la chambre du réacteur CVD et de son intérieur.

9. Sous-système de réacteur selon la revendication 8, dans lequel les capteurs comprennent en outre un ou plusieurs capteurs parmi un capteur pour déterminer la composition de gaz internes de la chambre du réacteur CVD en mesurant les propriétés spectrales de la lumière transmise à travers les gaz, un capteur pour déterminer des températures internes de la chambre du réacteur CVD en mesurant la radiation émise à l'intérieur de la chambre du réacteur, un capteur pour déterminer l'épaisseur d'une surface à l'intérieur de la chambre du réacteur en mesurant la radiation réfléchie par la surface, et un capteur pour déterminer la rugosité d'une surface à l'intérieur de la chambre du réacteur en mesurant la radiation réfléchie par la surface.

10. Sous-système de réacteur selon la revendication 8, comprenant en outre une pluralité de modules de fonction métrologiques qui sont supportés par l'enceinte du réacteur de manière à mesurer des conditions dans une pluralité de portions différentes de l'intérieur de la chambre du réacteur CVD.

11. Procédé de configuration d'un sous-système modulaire de réacteur CVD comprenant une enceinte du réacteur modulaire supportant une chambre du réacteur CVD et une pluralité de modules de fonction indépendants, les modules de fonction indépendants étant supportés par l'enceinte du réacteur adjacente aux parois extérieures de la chambre du réacteur CVD mais étant autrement structurellement indépendants de l'enceinte du réacteur, chaque module de fonction indépendant fournissant une ou plusieurs fonctions à des portions proches de la chambre du réacteur CVD et de son intérieur qui sont utiles à des processus mis en oeuvre à l'intérieur de la chambre du réacteur CVD, le procédé comprenant :
la sélection d'un ou plusieurs modules de fonction indépendants ;
pour chaque module de fonction sélectionné, la sélection d'une portion correspondante de la chambre CVD et de son intérieur ;
l'élimination de tout module de fonction supporté par l'enceinte du réacteur proche de portions sélectionnées de la chambre du réacteur CVD et de son intérieur ; et
le support de chaque module de fonction sélectionné sur l'enceinte du réacteur adjacente aux parois extérieures de la chambre du réacteur CVD qui sont proches de la portion correspondante de la chambre du réacteur CVD et de son intérieur sélectionnés pour ce module de fonction ;
dans lequel les modules de fonction sélectionnés comprennent en outre un ou plusieurs capteurs pour mesurer les conditions dans des portions proches de la chambre du réacteur CVD et de son intérieur, ou un ou plusieurs modules de fonction métrologiques pour mesurer des conditions sélectionnées à l'intérieur de la chambre du réacteur CVD ; et
dans lequel les modules de fonction indépendants sont interchangeables.

12. Procédé selon la revendication 11, dans lequel les modules de fonction sélectionnés comprennent en outre un ou plusieurs modules de fonction de chauffage pour fournir de la chaleur à la chambre du réacteur CVD et à son intérieur, et dans lequel un module de fonction déjà supporté par l'enceinte du réacteur proche d'une portion sélectionnée est éliminé s'il fournit une fonction similaire à la fonction fournie par le module sélectionné à monter sur la portion sélectionnée.

13. Procédé selon la revendication 12, dans lequel, pour chaque module de fonction de chauffage sélectionné, une portion correspondante de la chambre du réacteur CVD et de son intérieur est sélectionnée de telle sorte que, quand le module de fonction de chauffage sélectionné est supporté près de la portion correspondante, de la chaleur est fournie par les modules de fonction de chauffage à la chambre du réacteur CVD et à son intérieur conformément à un profil de chauffage préféré déterminé en fonction d'un processus CVD particulier à mettre en oeuvre.

14. Procédé selon la revendication 13, dans lequel, pour chaque module de fonction métrologique sélectionné, une portion correspondante de la chambre du réacteur CVD et de son intérieur est sélectionnée de telle sorte que, quand le module de fonction métrologique sélectionné est supporté près de la portion correspondante, des mesures de l'intérieur de la chambre du réacteur CVD sont effectuées conformément à un profil de mesure préféré déterminé en fonction d'un processus CVD particulier à mettre en oeuvre.
